(19) Europäisches Patentamt / European Patent Office / Office européen des brevets

(11) **EP 2 612 755 B1**

(12) **EUROPEAN PATENT SPECIFICATION**

(45) Date of publication and mention
of the grant of the patent:
**20.03.2019 Bulletin 2019/12**

(51) Int Cl.:
*D06N 3/00* *(2006.01)*      *H01L 23/373* *(2006.01)*
*H05K 7/20* *(2006.01)*      *C09J 7/29* *(2018.01)*

(21) Application number: **11821577.1**

(86) International application number:
**PCT/JP2011/068772**

(22) Date of filing: **19.08.2011**

(87) International publication number:
**WO 2012/029560 (08.03.2012 Gazette 2012/10)**

(54) **THERMALLY CONDUCTIVE SHEET**

WÄRMELEITENDE FOLIE

FEUILLE THERMOCONDUCTRICE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.08.2010 JP 2010194997**

(43) Date of publication of application:
**10.07.2013 Bulletin 2013/28**

(73) Proprietor: **SEKISUI POLYMATECH CO., LTD.
Saitama 338-0837 (JP)**

(72) Inventor: **WATANABE Yasuyoshi
Tokyo 114-0014 (JP)**

(74) Representative: **Schmid, Wolfgang
Lorenz & Kollegen
Patentanwälte Partnerschaftsgesellschaft mbB
Alte Ulmer Strasse 2
89522 Heidenheim (DE)**

(56) References cited:
WO-A1-95/02505          WO-A1-2005/083783
JP-A- 11 317 592         JP-A- H09 501 016
JP-A- 2000 124 660       JP-A- 2000 334 231
JP-A- 2002 046 137       JP-A- 2003 218 296
JP-A- 2003 249 781       JP-A- 2010 093 045
US-A- 6 074 963

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present invention relates to a thermally conductive sheet used for measures against heat, such as dissipation and cooling of heat generated from electronic components used in electronic apparatuses, various types of displays, cells and other apparatuses and equipment.

Background Art

Since some electronic components, such as a CPU, mounted in an electronic apparatus are heating elements, the electronic apparatus includes a radiator, such as a heat sink, for cooling. A thermally conductive sheet is disposed between a heating element and the radiator so as to promote heat conduction from the heating elements to the radiator. The use of the thermally conductive sheet increases the heating surface area between the heating element and the radiator, and thus efficiently releases heat from the heating element to the radiator.

In order to reduce the thermal resistance of a thermally conductive sheet, which is an index of difficulty of heat conduction, it is required that the thermally conductive sheet to conform to the shapes of the heating element and radiator and be in good contact with the heating element and radiator. From this viewpoint, it is desirable to use a flexible thermally conductive sheet. However, if the flexibility of the thermally conductive sheet is increased, the adhesion of the sheet is increased. This makes it difficult to attach the sheet to the heating element. Also, if a stack of such sheets is stored before shipping, the sheets may adhere to each other and become difficult to separate from each other.

Also, the thinner the thermally conductive sheet, the higher the thermal conductivity. From this viewpoint, it is desirable to use a thinner thermally conductive sheet. However, an excessively thin sheet is likely to cause inconvenience such as elongation, breakage and wrinkles, and thus the handleability of the sheet becomes poor.

As a measure against poor handleability, Japanese Unexamined Patent Application Publication Nos. 7-014950 (PTL 1) and 7-266356 (PTL 2) disclose a rubber or gel-type thermally conductive sheet provided with a mesh reinforcement, such as a glass, metal or resin fabric, therein or on the surface thereof. Such a thermally conductive sheet is sufficiently flexible in the thickness direction thereof so as to conform to the shape of the adjacent parts and come into good contact with the adjacent parts because of the presence of a rubber or gel layer, and is strong in the surface direction thereof because of the presence of the mesh reinforcement. Accordingly, the thermally conductive sheet is easy to handle in a mounting operation and, in addition, can readily conduct heat.

Since the mesh reinforcement has mesh holes, the thermally conductive rubber or gel layer passes through the holes and, thus, the thermal conductivity is enhanced. The mesh reinforcement has a structure in which fibers of the mesh reinforcement are interwoven, and can produce a higher reinforcing effect than other types of reinforcement, such as a film or sheet simply having through holes. Accordingly, it is expected that the thermally conductive sheet can be satisfactorily used even if the thickness is reduced to enhance the thermal conductivity.

A thermally conductive sheet according to the preamble of claim 1 is known from WO 95/02505 A1.

Citation List

Patent Literature

PTL 1: Japanese Unexamined Patent Application Publication No. 7-014950
PTL 2: Japanese Unexamined Patent Application Publication No. 7-266356

Summary of Invention

Technical Problem

However, the mesh reinforcement is in a form in which the intersections of threads of the fabric protrude. The protruding intersections can trap air bubbles. If air bubbles are trapped, an air layer is formed in the thermally conductive sheet and reduces the thermal conductivity. In addition, as for the physical properties, the strength is reduced, and such a problem as the sheet becomes liable to tear tends to occur.

The present invention is intended to solve the above issues, and an object of the invention is to provide a thermally conductive sheet that includes a mesh reinforcement so as to be easy to handle, and that is designed for easy manufacture so as not to easily trap air bubbles when being manufactured.

Another object is to provide a thermally conductive sheet that prevents air bubbles from being trapped thereto so as to ensure high thermal conductivity, and that is so strong that does not easily tear.

Solution to Problem

In order to achieve these objects, the following features are provided.

A thermally conductive sheet according to claim 1 is provided. The thermally conductive sheet includes a mesh sheet and a thermally conductive composition coating both sides of the mesh sheet so as to form a thermally conductive layer. The thermally conductive composition contains a resin composition and a thermally conductive filler. The mesh sheet has mesh holes defined by warp threads and woof threads extending in two directions in which the threads intersect with each other, and has a thickness of 50% to 90% of the total of the warp thread diameter and the woof thread diameter. The intersections of the warp threads and the woof threads each have an bubble inclusion inhibition part that reduces a gap formed at the intersections of the warp threads and the woof threads so that air bubbles are prevented from being trapped in the interface between the thermally conductive composition and the mesh sheet.

Since the mesh sheet that is a reinforcing member is embedded in the thermally conductive composition containing a resin composition and a thermally conductive filler, the thermally conductive sheet is stronger than a thermally conductive sheet in which the mesh sheet is not embedded, and can be easy to handle.

In addition, since the mesh sheet is used as a mesh reinforcement, the thermally conductive composition easily passes through the through holes of the mesh sheet to form a thermally conductive layer continuous from one side of the thermally conductive sheet to the other. Accordingly, the mesh sheet does not interfere with heat conduction, so that a capability of heat conduction provided by the thermally conductive layer is exhibited.

Furthermore, since bubble inclusion inhibition parts are formed to prevent air bubbles from being trapped in the interface between the thermally conductive layer and the mesh sheet, the thermally conductive composition can flow into the intersections of the threads during the manufacture of the thermally conductive sheet, and thus the occurrence of air bubbles can be made difficult.

In particular, by forming the mesh of the mesh sheet using only warp threads and woof threads extending in two directions in which the threads intersect with each other, the mesh is formed in a simple manner in comparison with a mesh formed using threads intertwined with each other in a complicated manner. Accordingly, the surface shape of the through holes defining the mesh holes is simple, and pits and projections that cause air bubbles to remain in the thermally conductive sheet are reduced.

If the thickness of the mesh sheet is set to 50% to 90% of the total of the warp thread diameter and the woof thread diameter, the warp threads and the woof threads are subjected to any treatment at their intersections, such as being collapsed or integrated, but not simply overlapped. Consequently, the thickness of the mesh sheet can be reduced, and, in addition, the surface area of the through holes defining the mesh holes is reduced. This makes it difficult that air bubbles remain in the thermally conductive sheet.

Also, since bubble inclusion inhibition parts are formed at the intersections of the threads for reducing the gap between the warp threads and the woof threads at their intersections and thus preventing air bubbles from being trapped in the interface between the thermally conductive composition and the mesh sheet, the occurrence of air bubbles is difficult in the manufacture of the thermally conductive sheet.

If bubble inclusion inhibition parts are not formed at the intersections of the mesh sheet, in contrast to the present invention in which bubble inclusion inhibition parts are formed at the intersections of the mesh sheet, the thermally conductive composition cannot easily penetrate the very small gaps around the intersections of the mesh sheet, formed by intersecting the threads forming the mesh sheet, and air bubbles remain in the thermally conductive layer. Consequently, the thermal conductivity may be degraded. In order to avoid such a problem, a design technique may be applied which optimizes conditions of the mesh sheet, such as the aperture ratio and the hole diameter, and physical properties of the thermally conductive composition, such as the viscosity and wettability. However, the present invention can prevent the occurrence of air bubbles without strictly setting such conditions or properties in the design technique.

Preferably, the mesh holes each have a width of 5 to 40 times of the warp thread diameter or the woof thread diameter. When the mesh holes each have a width of five times or more of the warp thread diameter or the woof thread diameter, the height of the through holes defining the mesh holes is reduced relative to the width of the through holes, and accordingly the thermally conductive composition can easily pass through the through holes. Consequently, a thermally conductive sheet in which air bubbles do not easily remain can be obtained. If the width exceeds 40 times, the effect of reinforcing may not be enhanced as expected.

Also, a thermally conductive sheet is provided which includes a mesh sheet and a thermally conductive composition coating both sides of the mesh sheet so as to form a thermally conductive layer. The thermally conductive composition contains a resin composition and a thermally conductive filler. The mesh sheet has mesh holes defined by threads intersecting with each other. The intersections of the threads each have an bubble inclusion inhibition part that prevents air bubbles from being trapped in the interface between the thermally conductive composition and the mesh sheet.

Since the mesh sheet that is a reinforcing member is embedded in the thermally conductive composition containing a resin composition and a thermally conductive filler, the thermally conductive sheet is stronger than a thermally conductive sheet in which the mesh sheet is not embedded, and can be easy to handle.

In addition, since the mesh sheet is used as a mesh reinforcement, the thermally conductive composition easily passes through the through holes of the mesh sheet to form a thermally conductive layer continuous from one side of the thermally conductive sheet to the other. Accordingly, the mesh sheet does not interfere with heat conduction, so that a capability of heat conduction provided by the thermally conductive layer is exhibited.

Furthermore, since bubble inclusion inhibition parts are formed to prevent air bubbles from being trapped in the interface between the thermally conductive layer and the mesh sheet, the thermally conductive composition can flow into the intersections of the threads during the manufacture of the thermally conductive sheet, and thus the occurrence of air bubbles can be made difficult.

According to the invention, the bubble inclusion inhibition part is defined by a fused portion formed by thermally fusing or welding the threads at the intersections. In other words, the bubble inclusion inhibition parts can be fused portions at which the intersections of the mesh sheet are thermally fused or welded.

Since the intersections of the mesh sheet are thermally fused or welded, the mesh sheet is flattened and the gaps at the intersections are hardly formed, in comparison with ordinary mesh sheets whose intersections are not fixed. Accordingly, the occurrence of air bubbles at the intersections is difficult during the manufacture of the thermally conductive sheet, and air bubbles can be prevented from being trapped.

Although the mesh sheet may be made of a resin or a metal, the use of a thermoplastic resin allows easy thermal fusion, and a desired mesh sheet can be formed easily and at a low cost.

According to the invention, the bubble inclusion inhibition part can alternatively be defined by a pressure-bonded portion formed by pressure-bonding the threads at the intersections. Since the bubble inclusion inhibition parts are defined by pressure-bonded portions, the intersections are flattened and the gaps at the intersections are hardly formed, in comparison with ordinary mesh sheets whose intersections are not fixed. Accordingly, the occurrence of air bubbles at the intersections is difficult when the thermally conductive sheet is formed by coating the mesh sheet with the thermally conductive composition, and air bubble can be prevented from being trapped.

As described above, since the intersections of the mesh sheet are flattened, because the bubble inclusion inhibition parts are fused portions or pressure-bonded portions, a thermally conductive sheet is formed in which the mesh sheet and the thermally conductive layer have substantially the same thickness. In other words, even though the mesh sheet and the thermally conductive layer have substantially the same thickness, the intersections are not exposed at the surface of the thermally conductive layer because the intersections of the mesh sheet are flattened. Thus, a thermally conductive sheet that is thin and easy to handle can be manufactured.

Furthermore, the thermally conductive layer may be a stack of an adhesive layer and a non-adhesive layer. In this instance, the mesh sheet can be embedded in the adhesive layer, the non-adhesive layer or the interface between the adhesive layer and the non-adhesive layer.

Since the thermally conductive layer is a stack of an adhesive layer and a non-adhesive layer, one side can be an adhesive surface and the other is a non-adhesive surface. Thus, work for attachment to electronic components becomes easy.

Advantageous Effects of Invention

The thermally conductive sheet of the present invention is easy to handle with a capability of heat conduction maintained, in comparison with thermally conductive sheets in which a mesh sheet is not embedded.

Also, since bubble inclusion inhibition parts are formed at the intersections of the mesh sheet, the thermally conductive sheet is such that air bubbles are difficult to trap into the thermally conductive layer.

Brief Description of Drawings

Fig. 1 is a plan view of a thermally conductive sheet according to an embodiment.
Fig. 2 is a sectional view taken along line SA-SA of Fig. 1.
Fig. 3 is a representation illustrating a state in which a mesh sheet is embedded in a thermally conductive layer.
Fig. 4 is a plan view of a mesh sheet.
Fig. 5 is a sectional view, corresponding to Fig. 6, of a mesh sheet in which intersections are not fixed.
Fig. 6 is a sectional view taken along line SB-SB of Fig. 4.
Fig. 7 is a sectional view, corresponding to Fig. 6, of a mesh sheet subjected to pressure bonding.

Fig. 8 is a sectional view, corresponding to Fig. 6, of a mesh sheet provided with resin-coated portions.

Fig. 9 is a representation of an embodiment of a method for manufacturing a thermally conductive sheet, illustrating a step in which a mesh sheet is disposed over a film sheet.

Fig. 10 is a representation of an embodiment of the method for manufacturing a thermally conductive sheet, illustrating a step in which a non-adhesive layer composition is applied over a film sheet so as to immerse the mesh sheet.

Fig. 11 is a representation of an embodiment of the method for manufacturing a thermally conductive sheet, illustrating a step in which an adhesive layer composition is applied onto the non-adhesive layer composition.

Fig. 12 is a sectional view, corresponding to Fig. 2, of a thermally conductive sheet according to another embodiment.

Fig. 13 is a sectional view, corresponding to Fig. 2, of a thermally conductive sheet according to still another embodiment.

Fig. 14 is a sectional view, corresponding to Fig. 2, of a thermally conductive sheet according to further embodiment.

Fig. 15 is a sectional view, corresponding to Fig. 2, of a thermally conductive sheet according to yet another embodiment.

Fig. 16 is an SEM image of the surface state of a thermally conductive sheet of Example 1.

Fig. 17 is an SEM image of the surface state of a thermally conductive sheet of Comparative Example 3.

Fig. 18 is a representation of a system for measuring the thermal resistance of a thermally conductive sheet.

Description of Embodiments

The present invention will be further described on the basis of the following embodiments. Common parts in the embodiments are designated by the same reference numerals, and the same description will not be repeated. The descriptions of common materials, operations, effects and so forth are also not repeated.

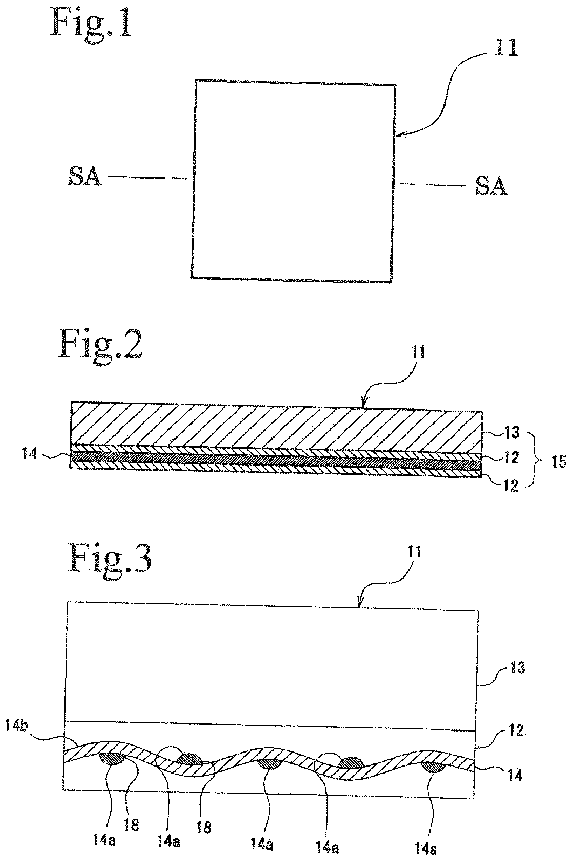

First Embodiment [Figs. 1 to 11]:

Fig. 1 shows a plan view of a thermally conductive sheet 11. The thermally conductive sheet 11 is a component of an electronic apparatus that can come in good contact with heating elements, such as an IC and a CPU, and radiators, such as a heat sink and a heat pipe. As shown in the sectional view of Fig. 2, a mesh sheet 14 is embedded within a sheet-like thermally conductive layer 15 of the thermally conductive sheet.

In the present embodiment, from the viewpoint of enhancing handleability, the thermally conductive layer 15 includes two layers of an adhesive layer 13 and a non-adhesive layer 12. The mesh sheet 14 is embedded in the non-adhesive layer 12 of the thermally conductive layer 15. The non-adhesive layer 12 passes through the mesh holes (through holes) in the grid-like mesh sheet 14, thus continuing from one side of the adhesive layer 13 (interface with the adhesive layer 13) to the other (external side).

Intersections of the mesh sheet 14 are each provided with an bubble inclusion inhibition part 18 for preventing air bubbles from being trapped therein.

Fig. 3 schematically shows a state in which the mesh sheet 14 is embedded in the thermally conductive layer 15.

The thermally conductive layer 15 is made of a thermally conductive composition containing a base material of a resin composition and a thermally conductive filler dispersed in the base material so as to help heat conduction.

The adhesive layer 13 of the thermally conductive layer 15 is adhesive and thus easily adheres to intended objects. On the other hand, the non-adhesive layer 12 does not easily adhere even if two non-adhesive layers 12 are brought into contact with each other unless pressure is applied, and does not easily adhere to hands of workers even if it comes into contact with the hands. In addition, even if the non-adhesive layer 12 is bonded to something by applying a pressure, it is liable to separate from the object it is bonded to.

The adhesive layer 13 and the non-adhesive layer 12 can easily be formed separately by varying the content of a crosslinking agent in the resin composition. The resulting thermally conductive layer 15 can exhibit good contact between the adhesive layer 13 and the non-adhesive layer 12. The adhesive layer 13 and the non-adhesive layer 12 may be formed of different materials.

The adhesive layer 13 of the thermally conductive layer 15 preferably has a hardness of 60 or less in terms of the value measured with a type E durometer specified in JIS K 6253 of Japanese Industrial Standards (hereinafter referred to as "E hardness"). If the E hardness of the thermally conductive layer 15 exceeds 60, the layer is unlikely to have sufficiently conformed to the change in shape of the heating element or radiator, and thus the contact between the heating element or radiator and the thermally conductive layer 15 is reduced. Consequently, the thermal conductivity of the thermally conductive sheet 11 may be reduced. If the E hardness of the thermally conductive layer 15 is 60 or less, the thermally conductive layer 15 can satisfactorily conform to the uneven surface of the heating element or radiator, and thus can ensure good contact between the heating element or radiator and the thermally conductive sheet 11. In addition, the thermally conductive layer 15 having an E hardness of 60 or less ensures that the thermally conductive sheet 11 has sufficient flexibility. Accordingly, the thermally conductive sheet 11 absorbs the impact on the heating element provided with the thermally conductive sheet 11, thus appropriately protecting the heating element. However, if the E hardness of the adhesive layer 13 is less than 10, it is preferable that a non-adhesive layer 12 be provided, as in the present embodiment. More specifically, when the non-adhesive layer 12 is provided, the E hardness of the adhesive layer 13 is more preferably in the range of 10 to 60.

On the other hand, from the viewpoint of the handling of the thermally conductive sheet 11, the E hardness of the adhesive layer 13 is preferably 60 to 90.

The thickness of the thermally conductive layer 15 is equal to or more than that of the mesh sheet 14, and is preferably 0.1 mm to 5 mm. If the thickness exceeds 5 mm, the capability of heat conduction may be degraded (the thermal resistance may increase). If the thickness is less than 0.1 mm, the thermally conductive sheet is difficult to handle even though the mesh sheet 14 is used.

The resin composition, which is one of the materials of the thermally conductive layer 15, may be prepared from a mixture that contains, for example, a base resin and a curing agent and that will be cured into a rubber or gel polymer base material when mixed. For example, a mixture of an uncrosslinked rubber and a crosslinking agent, or a mixture of an uncrosslinked rubber containing a crosslinking agent and a crosslinking promoter may be used. Also, the curing reaction of the resin composition may be performed at room temperature or by heating. For a silicone rubber, the resin composition may be a mixture of a silicone rubber base resin and a curing agent, for example, a mixture of a silicone raw rubber having a vinyl group and a peroxide. For a polyester-based thermoplastic elastomer or a polyamide-based thermoplastic elastomer, the resin composition may be a mixture of a diol and a dicarboxylic acid. For a polyurethane-based thermoplastic elastomer, the resin composition may be a mixture of diisocyanate and a diol. In the resin composition mentioned herein, one of at least two components of the mixture is a base resin, and the other is a curing agent. Any one may be defined as the base resin and any one may be defined as the curing agent. For example, one of the components having a lower content may be the base resin, or one of the components having a lower viscosity may be the base resin.

The polymer base material may contain only a base resin without containing a curing agent. In the present invention, therefore, the resin composition or the polymer base material does not necessarily have as high a molecular weight as resins or polymers generally have.

The polymer base material or the mixture of a base resin and a curing agent may contain any additive so as to enhance the productivity, weather resistance, heat resistance or other properties of the thermally conductive sheet 11. Examples of such an additive include various function enhancers, such as a plasticizer, a reinforcement, a coloring agent, a heat resistance enhancer, a coupling agent, a flame retardant, an adhesive, a catalyst, a curing retarder, and a degradation inhibitor.

The thermally conductive filler may be fine powder of a metal oxide, a metal nitride, a metal carbide, a metal hydroxide, carbon fibers or the like. Metal oxides include aluminum oxide, magnesium oxide, zinc oxide, and quartz, and metal nitrides include boron nitride and aluminum nitride. The metal carbide may be silicon carbide, and the metal hydroxide may be aluminum hydroxide. The carbon fiber may be a pitch-based carbon fiber, PAN-based carbon fiber, a carbonized resin fiber, a graphitized resin fiber or the like. Such a thermally conductive filler can be oriented in a certain direction with respect to the thermally conductive layer, and from the viewpoint of enhancing thermal conductivity, it is preferably oriented.

The mesh sheet 14 is a network structure formed, for example, by weaving threads into a sheet of plain weave, jacquard weave, Dutch weave, figured Dutch weave or the like, by stacking layers of threads into a sheet without weaving, or by knitting threads into a sheet.

The shape of mesh holes is not limited, and the mesh holes continue from one side of the mesh sheet 14 to the other. Preferably, such through holes defining the mesh holes are formed along a direction perpendicular to the surface of the mesh sheet 14. From this point of view, a plain weave sheet is preferred to a Dutch weave sheet.

It is desirable that the overlap of the threads forming the mesh be small in the direction perpendicular to the surface of the mesh sheet 14. Accordingly, a plain weave sheet is preferred to a jacquard weave sheet.

In addition, it is desirable that the mesh holes be formed in a regular manner because regular mesh holes lead to uniform heat conduction. Accordingly, a woven sheet is preferred to a nonwoven sheet or knitted sheet.

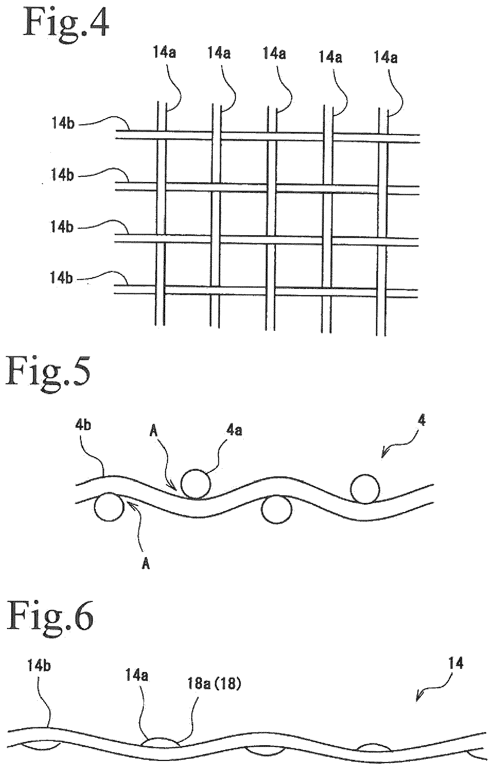

From the viewpoint of reducing the size of gaps that hinder the thermally conductive composition from penetrating the vicinities of the intersections of the threads, the mesh sheet 14 shown in Fig. 4 is most preferred, which is formed of a layer of threads constituted by warp threads and woof threads extending in two directions and has intersections of threads each of which is an overlap of a single warp thread and a single woof thread.

The threads of the mesh sheet 14 may be made of glass, a metal such as iron, copper, brass, stainless steel, aluminum, or nickel, or a thermoplastic resin such as polyethylene (PE), polypropylene (PP), polyethylene terephthalate (PET), or polyimide (PI).

If the intersections of the mesh sheet 14 are subjected to thermal fusion or pressure bonding, a thermoplastic resin is suitable.

The bubble inclusion inhibition parts 18 are formed at the intersections of the threads forming the mesh, and prevent air bubbles from being trapped in the interface between the thermally conductive composition and the mesh sheet.

At the intersections of a mesh sheet 4 as shown in Fig. 5, at which threads cross simply, the contact area of the warp thread 4a and the woof thread 4b is small, and gaps A formed around the intersections are large. If gap A is formed, air bubbles are likely to be trapped in gap A when the mesh sheet 4 is covered with the resin composition. Accordingly, the size of gap A is reduced so as to prevent air bubbles from remaining when the mesh sheet 14 has been covered with the resin composition. Thus, the bubble inclusion inhibition part 18 can be a portion at which the size of gap A is reduced.

In a more specific embodiment, the bubble inclusion inhibition part 18 may be a collapsed portion 18 formed by collapsing the threads 14a and 14b at the intersection of the threads 14a and 14b, as shown in Fig. 6.

The collapsed portion 18 is formed as a fused portion 18a at which the intersection of the warp thread 14a and the woof thread 14b has been thermally fused or welded. Thermal fusion and welding each imply that threads are melted and then hardened to adhere to each other. Thermoplastic resin threads can be thermally fused, and metal threads can be melted by welding.

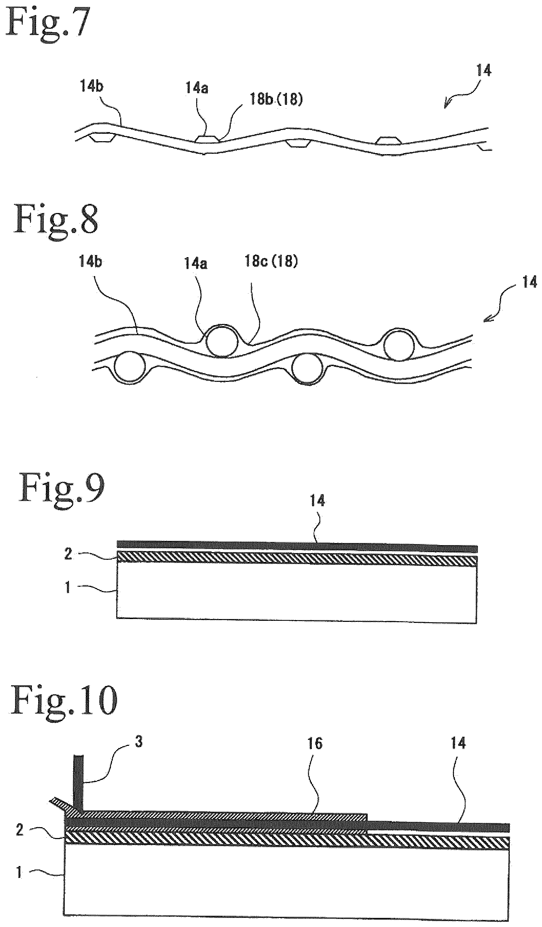

The collapsed portion 18 may be formed as a pressure-bonded portion 18b at which the intersection has been subjected to pressure bonding, as shown in Fig. 7.

Since the intersections of the mesh sheet 14 are provided with collapsed portions 18 as fused portions or pressure-bonded portions, the rising portions of the intersections are flattened as shown in Figs. 6 and 7. In other words, the contact area of the warp thread 14a and the woof thread 14b (hereinafter may be referred to as warp and woof threads together) is thus increased, so that the gaps at the intersections of the warp and woof threads almost disappear. This makes it difficult to generate air bubbles from the intersections of the mesh sheet 14. Hence, when the thermally conductive sheet 11 is formed by coating both sides of the mesh sheet 14 with a thermally conductive composition, the thermally conductive composition is easily applied uniformly to the warp and woof threads of the mesh sheet 14. Thus, the trapping of air bubbles can be prevented. When the ordinary mesh sheet 4, shown in Fig. 5, not provided with such bubble inclusion inhibition parts 18 is used, it is difficult that the thermally conductive composition penetrates into gaps A at the intersections of the warp and woof threads 4a and 4b of the mesh sheet 4. Thus, the thermally conductive sheet is formed in a state where air remains in the gaps. Consequently, the thermal conductivity can be degraded. In order to avoid this problem, an appropriate design technique is required to optimize the conditions of the mesh sheet 14, such as the aperture ratio and the diameter of the mesh holes, and the physical properties of the thermally conductive composition, such as the viscosity and the wettability. In the present embodiment, however, such a design technique is not required.

The conditions for thermal fusion or welding depend on the properties of the material. If a thermoplastic resin is used, it can be heat-treated at a temperature around the melting point of the thermoplastic resin for about 10 seconds to 10 minutes. A commercially available mesh sheet 14 having fused intersections may be used.

For pressure-bonding, the intersections of threads can be subjected to pressure bonding with a press, a calendar (rolling) machine, a roller, or the like. Also, a commercially available mesh sheet 14 that has been subjected to pressure bonding may be used.

If the threads 14a and 14b are made of a metal, it is difficult to reduce the size of the gaps A formed at the intersections of the threads 14a and 14b, even if the threads 14a and 14b are welded. Accordingly, a mesh sheet 14 having pressure-bonded intersections is more suitable than a mesh sheet having welded intersections. In contrast, if a resin material is used, the size of the gaps A can be reduced by either thermal fusion or pressure-bonding, and accordingly, either is suitable.

In comparison between a metal and a resin mesh sheet 14, the metal sheet is superior in reinforcing the thermally conductive sheet, and can be formed thinly.

In another embodiment, the bubble inclusion inhibition part 18 may be defined by a resin-coated portion 18c formed over the intersections of the threads 14a and 14b, as shown in Fig. 8. This is because the resin coating can fill the gaps A formed at the intersections of the warp threads 14a and the woof threads 14b. Therefore, the resin-coated portion 18c is formed simply at the intersections of the threads 14a and 14b, more specifically around the intersections.

Alternatively, from the viewpoint of workability and easy manufacture, the resin-coated portion 18c may be formed over the entire surface of the mesh sheet 14 to the extent that the mesh holes are not filled. Materials that can be used for the resin coating include liquid compositions, liquid polymers, paints, inks and adhesives of silicone, acrylic, polyurethane, epoxy or polyisobutylene. Among these, silicone, polyurethane and polyisobutylene materials are preferred because the thermally conductive layer can be formed of the same material and these materials are flexible.

If a resin mesh sheet is used, it is advantageously easy to form a resin coating. If a metal mesh sheet is used, a high reinforcing effect is produced, and the thickness can be reduced.

As for the dimensions of the mesh sheet 14, the mesh sheet has a thickness of 10 μm to 500 μm, a hole diameter of 200 μm to 1200 μm, an aperture ratio of 40% to 90%, and a thread diameter of 20 μm to 300 μm, from the viewpoint of maintaining the capability of heat conduction of the thermally conductive layer 15 and from the viewpoint of the handleability of the thermally conductive sheet 11 integrated with the thermally conductive layer 15.

An embodiment of the manufacturing method of the thermally conductive sheet 11 will now be described.

First, a thermally conductive composition for the adhesive layer 13 (hereinafter referred to as "adhesive layer composition 17") is prepared by mixing a resin composition and a thermally conductive filler with a stirrer. At the same time, a thermally conductive composition for the non-adhesive layer 12 (hereinafter referred to as "non-adhesive layer composition 16") is prepared in which the curing agent content is higher than that in the adhesive layer composition 17.

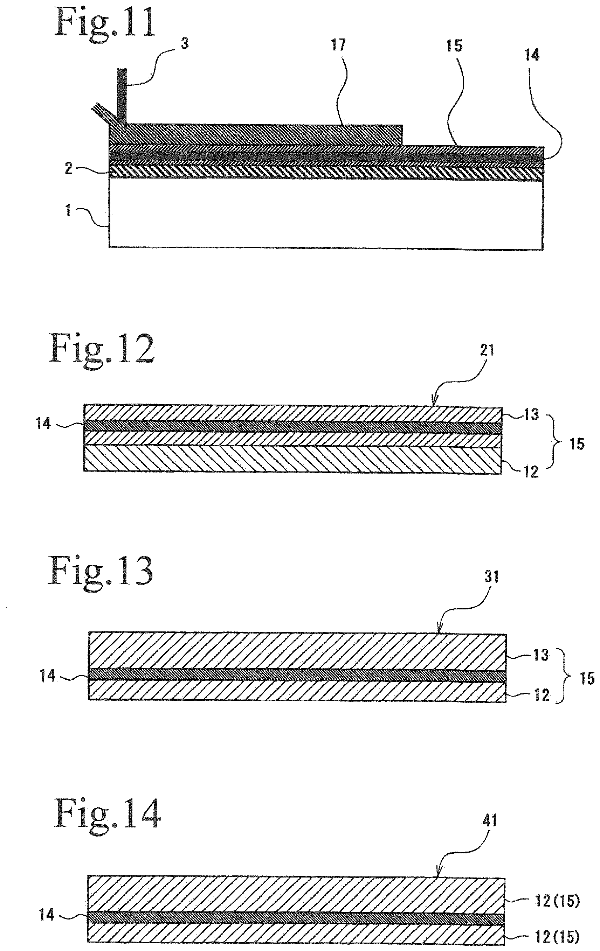

Then, as shown in Fig. 9, a mesh sheet 14 is disposed with a very small gap over a film sheet 2 on a conveyor 1. Then, as shown in Fig. 10, the non-adhesive layer composition 16 is applied onto the film sheet 2 for sheet forming so as to immerse the mesh sheet 14. Furthermore, the adhesive layer composition 17 is applied for sheet forming, as shown in Fig. 11. In the course of this process, the viscosity of the non-adhesive layer composition 16 is adjusted or a mesh sheet 14 having an appropriate aperture ratio is selected so that the non-adhesive layer composition 16 can pass through the through holes of the mesh sheet 14, and thus a non-adhesive layer 12 is formed on the upper and lower surfaces (both sides) of the mesh sheet 14.

Then, both of the thermally conductive compositions are cured to form a thermally conductive layer 16 that is a stack of the non-adhesive layer 12 and the adhesive layer 13. Thus, a thermally conductive sheet 11 is obtained in which the mesh sheet 14 is embedded in the non-adhesive layer 12.

Alternatively, the thermally conductive sheet 11 may be manufactured by the following method. After the thermally conductive compositions are prepared, the adhesive layer 13 is formed in advance by applying the adhesive layer composition 17 to the film sheet 2 for sheet forming. Then, the mesh sheet 14 is disposed with a very small gap over the adhesive layer 13, and the non-adhesive layer composition 16 is applied for sheet forming so as to immerse the mesh sheet 14 (not shown). Thus, a thermally conductive sheet 11 in which the mesh sheet 14 is embedded in the non-adhesive layer 12 is obtained by forming a thermally conductive layer 15 that is a stack of the non-adhesive layer 12 and the adhesive layer 13.

Since the mesh sheet 14 is embedded in the non-adhesive layer 12, the thermally conductive sheet 11 can exhibit a higher strength than the case in which the mesh sheet 14 is embedded in the adhesive layer 12. In addition, since the non-adhesive layer 12, in general, tends to be harder than the adhesive layer 13, and since the mesh sheet 14 is embedded in the non-adhesive layer 12 harder than the adhesive layer 13, the warp and woof threads of the mesh sheet 14 are not easily exposed at the surface of the thermally conductive layer 15 even if a high load is placed on the thermally conductive sheet 11. If the mesh sheet 14 is embedded in the adhesive layer 13, the adhesive layer 13 is not easily spread in the plane direction even when receiving a load. However, if the mesh sheet 14 is embedded in the non-adhesive layer 12, the adhesive layer 13 can be easily spread by receiving a load, and thus can exhibit its feature.

Second Embodiment [Fig. 12]:

In the above embodiment, the thermally conductive layer 15 has a multilayer structure including an adhesive layer 13 and a non-adhesive layer 12, and the mesh sheet 14 is embedded within the non-adhesive layer 12. In the thermally conductive sheet 21 illustrated in the present embodiment, the mesh sheet 14 is embedded within an adhesive layer 13, as shown in Fig. 12.

The thermally conductive sheet 21 may be manufactured as follows.

The mesh sheet 14 is embedded in the adhesive layer 13 in the same manner as in the process of the manufacturing method of the thermally conductive sheet 11 described in the foregoing embodiment in which the mesh sheet 14 is embedded in a non-adhesive layer 12. Also, the non-adhesive layer 12 is formed on the adhesive layer 13 in the same manner as in the step of forming the adhesive layer 13 on the non-adhesive layer 12. Thus, the thermally conductive sheet 21 is manufactured.

Since the mesh sheet 14 is embedded in the adhesive layer 13, the strength of the adhesive layer 13, which is often formed more weakly than the non-adhesive layer 12, can be increased, and thus the total strength of the thermally conductive sheet 21 can be increased to some extent. Consequently, the thermally conductive sheet 21 can exhibit good handleability.

In addition, by forming the adhesive layer 13 to a larger thickness than the non-adhesive layer 12, the adhesive layer 13 can maintain a flexibility at the external surface and the interface with the non-adhesive layer 12 even though the mesh sheet 14 is embedded in the adhesive layer 13, and a capability of heat conduction provided by the adhesive layer 13 is likely to be exhibited.

Third Embodiment [Fig. 13]:

In the thermally conductive sheet 31 described in the present embodiment, the mesh sheet 14 is embedded around the interface between the adhesive layer 13 and the non-adhesive layer 12, as shown in Fig. 13.

For manufacturing the thermally conductive sheet 31, first, the non-adhesive layer composition 16 that will form the non-adhesive layer 12 is applied to the film sheet 2. Then, the mesh sheet 14 is disposed with a pressure applied so as to be pressed into the surface of the non-adhesive layer composition 16. The non-adhesive layer composition 16 in which about a half of the mesh sheet 14 is soaked is coated with the adhesive layer composition 17 for sheet forming. Then, both of the thermally conductive compositions are cured to form the thermally conductive sheet 31 in which the mesh sheet 14 is embedded in a stack of the non-adhesive layer 12 and the adhesive layer 13 in the interface of these layers.

The order of the steps of applying the non-adhesive layer 12 and applying the adhesive layer 13 may be reversed.

Since the mesh sheet 14 is embedded in the interface between the non-adhesive layer 12 and the adhesive layer 13, both advantages of the case in which the mesh sheet is embedded in the non-adhesive layer 12 (first embodiment) and the case in which it is embedded in the adhesive layer 13 (second embodiment) can be taken.

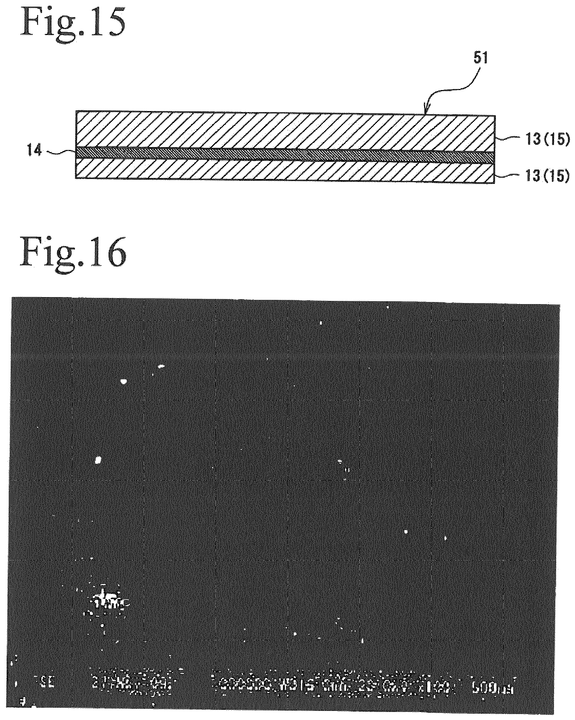

Other Embodiment [Figs. 14 and 15]:

As shown in Fig. 14, the thermally conductive layer 15 may be composed of only the adhesive layer 13. Alternatively, as shown in Fig. 15, the thermally conductive layer 15 may be composed of only the non-adhesive layer 12. In these cases, the mesh sheet 14 is embedded in the adhesive layer 13 or the non-adhesive layer 12.

When the thermally conductive layer 15 is composed of the adhesive layer 13, the contact with a member to be attached becomes good, and thus the capability of heat conduction can be enhanced. In this instance, in view of handleability, a metal mesh having a higher strength is suitably used. When the thermally conductive layer 15 is composed of the non-adhesive layer 12, the surface of the sheet is not adhesive, and thus work for attachment is easy. In addition, the manufacturing cost can be reduced to such an extent as the thermally conductive layer 15 does not have the two-layer structure.

EXAMPLES

The present invention will be further described in detail with reference to Examples and Comparative Examples.

EXAMPLE 1

A thermally conductive sheet having the structure shown in Fig. 2 was formed in the following process.

First, 200 parts by mass of aluminum oxide particles (average particle size 50 $\mu$m) and 200 parts by mass of aluminum hydroxide particles (average particle size 50 $\mu$m) were mixed as the thermally conductive filler to 100 parts by mass of a liquid silicones polymer as the resin composition. The mixture was kneaded for 30 minutes with defoaming with a planetary mixer, thus preparing an adhesive layer composition used for forming an adhesive layer. Also, a non-adhesive layer composition having a higher curing agent content was prepared in the same manner. A test piece was formed using the adhesive layer composition and the non-adhesive layer composition, and the E hardness was measured. As a result, the E hardness of the adhesive layer was 5, and the E hardness of the non-adhesive layer was 70.

Subsequently, a mesh sheet (thread diameter 98 $\mu$m, mesh hole diameter 550 $\mu$m, aperture ratio 72%, thickness 150 $\mu$m) having fused portions formed by thermally fusing the intersections was disposed with a very small gap over a 150 $\mu$m thick PET film disposed on a conveyor, as shown in Fig. 9. Then, the non-adhesive layer composition was applied onto the PET film so as to immerse the mesh sheet in a sheet forming line performing a comma coater method, as shown in Fig. 10. Subsequently, the adhesive layer composition was applied in the same manner as the non-adhesive layer composition, as shown in Fig. 11. The non-adhesive layer composition and the adhesive layer composition were cured to form a thermally conductive layer that was a stack of a non-adhesive layer and an adhesive layer by heat treatment in a curing oven at 120°C for 10 minutes. Thus, a thermally conductive sheet (thickness 0.72 mm) was obtained in which the mesh sheet was embedded in the non-adhesive layer.

EXAMPLE 2

A thermally conductive sheet was formed in the same manner as in Example 1 except that the non-adhesive layer was not formed.

EXAMPLE 3

A thermally conductive sheet was formed in the same manner as in Example 1 except that a metal mesh sheet (thread diameter 80 $\mu$m, mesh hole diameter 238 $\mu$m, aperture ratio 56%, thickness 230 $\mu$m) having pressure-bonded portions formed by pressure-bonding the intersections was used instead of the mesh sheet of Example 1.

EXAMPLE 4

A thermally conductive sheet was formed in the same manner as in Example 1, except that a PET mesh sheet (thread diameter 71 μm, mesh hole diameter 292 μm, aperture ratio 65%, thickness 125 μm) whose intersections were not fixed was used instead of the mesh sheet of Example 1. The PET mesh sheet was coated in advance, over the entire surface thereof including the intersections, with a silicone coating formed by applying a silicone paint over the entire surface of the mesh sheet and drying the paint.

COMPARATIVE EXAMPLE 1

A thermally conductive sheet was formed in the same manner as in Example 1 except that a mesh sheet was not used.

COMPARATIVE EXAMPLE 2

A thermally conductive sheet was formed in the same manner as in Comparative Example 1 except that the non-adhesive layer was not formed.

COMPARATIVE EXAMPLE 3

A thermally conductive sheet was formed in the same manner as in Example 1 except that a PET mesh sheet (thread diameter 71 μm, mesh hole diameter 292 μm, aperture ratio 65%, thickness 125 μm) whose intersections were not fixed was used instead of the mesh sheet of Example 1.
The Examples and Comparative Examples were evaluated for the following properties. The results are shown in Table 1.

(Check for Air Bubbles)

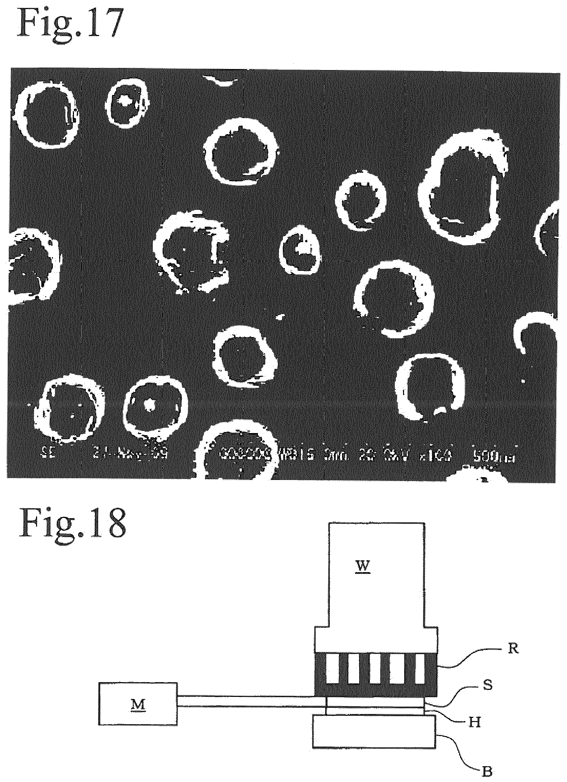

Each thermally conductive sheet was checked for the presence or absence of air bubbles by observing the surface state of the sample through a scanning electron microscope (SEM). For the thermally conductive sheets in which the mesh sheet was embedded, the surface at the side closer to the mesh sheet was observed in order to clearly check the effect of embedding the mesh sheet.
By way of example, Fig. 16 shows an SEM image of Example 1 and Fig. 17 shows an SEM image of Comparative Example 3. In the column of "air bubbles" in Table 1, "present" means that air bubbles were observed as shown in Fig. 17, and "absent" means that air bubbles were not observed, as shown in Fig. 16. In the cases of "present", however, air bubbles of several tens of μm to several hundreds of μm, more specifically, air bubbles of about 50 μm to 300 μm, were observed.

(Thickness)

The thickness of the thermally conductive sheet of each example was measured with a thickness gage. The results are shown in the column of "Thickness" in Table 1.

(Tensile Strength)

The thermally conductive sheet of each Example was cut into a test piece for tensile test. The tensile strength was measured by performing a tensile test on the test piece in accordance with JIS K 6251 of Japanese Industrial Standards.

(Thermal Resistance)

The thermal resistance of the thermally conductive sheet of each Example was measured. As shown in Fig. 18, a test piece S (one of pieces of the Examples, cut into 10 mm x 10 mm) was pinched between a heating element H and a radiator R on a substrate B, and a constant load (20 N) is applied to the test piece S with a weight W placed on the radiator. Then, after the test piece was allowed to stand for 10 minutes under conditions where the heating element H were heating, the test piece was measured for temperature T1 of the external surface on the side of the heating element H and temperature T2 of the external surface on the side of the radiator R. Then, the thermal resistance of the test piece was calculated from the following equation (1). Although a typical heating element H is an electronic component such as a CPU, a heater having a calorific value of 4 W was used as the heating element in this test in order to perform evaluations for the properties of the sheet simply and rapidly.

$$\text{Thermal resistance (°C/W)} = (T1\ (°C) - T2\ (°C))\ /\ \text{Calorific value (W)}\qquad(1)$$

[Table 1]

| | Thickness (mm) | Adhesive layer | Non-adhesive layer | Mesh sheet | Evaluation | | |
| --- | --- | --- | --- | --- | --- | --- | --- |
| | | | | | Air bubbles | Tensile strength (MPa) | Thermal resistance (°C/W) |
| Example 1 | 0.72 | Present | Present | Present (fused) | Absent | 5.58 | 2.750 |
| Example 2 | 0.64 | Present | Absent | Present (fused) | Absent | 4.92 | 2.846 |
| Example 3 | 0.66 | Present | Present | Present (pressure-bonded) | Absent | 11.54 | 2.913 |
| Example 4 | 0.69 | Present | Present | Present (resin-coated) | Absent | 0.54 | 2.895 |
| Comparative Example 1 | 0.55 | Present | Present | Absent | Absent | 0.15 | 1.675 |
| Comparative Example 2 | 0.58 | Present | Absent | Absent | Absent | 0.09 | 2.525 |
| Comparative Example 3 | 0.72 | Present | Present | Present (ordinary) | Present | 0.49 | 3.000 |

The thermally conductive sheets of Examples 1 to 4 had high tensile strengths, thus exhibiting an advantageous effect in reinforcement, and were easy to handle. In addition, air bubbles were hardly observed.

On the other hand, the thermally conductive sheets of Comparative Examples 1 and 2 exhibited low tensile strengths and were difficult to handle. As for the thermally conductive sheet of Comparative Example 3, the ease of handling was satisfactory, but air bubbles were observed.

The differences in the results of tensile strength in comparison between Examples 1 to 4 and Comparative Examples 1 and 2 show that the presence of the mesh sheet increases the tensile strength and produces a reinforcing effect, and makes the sheet easy to handle.

Furthermore, in the results of comparison of the presence or absence of air bubbles between Examples 1 to 4 and Comparative Example 3, air bubbles were hardly observed in the cases in which bubble inclusion inhibition parts were formed, whereas air bubbles were observed in the cases in which bubble inclusion inhibition parts were not formed.

Reference Signs List

| 1 | conveyor |
| 2 | film sheet |
| 3 | blade |
| 4 | mesh sheet |
| 4a | warp thread |
| 4b | woof thread |
| 11, 21, 31, 41, 51 | thermally conductive sheet |

| 12 | non-adhesive layer |
|---|---|
| 13 | adhesive layer |
| 14 | mesh sheet |
| 14a | warp thread |
| 14b | woof thread |
| 15 | thermal conduction layer |
| 16 | non-adhesion layer composition |
| 17 | adhesion layer composition |
| 18 | bubble inclusion inhibition part |
| 18a | fused portion |
| 18b | pressure-bonded portion |
| 18c | resin-coated portion |
| A | gap |
| S | test piece |
| R | radiator |
| H | heating element |
| W | weight |
| M | measurement instrument |

**Claims**

1.  A thermally conductive sheet (11,21,31,41,51) comprising a mesh sheet (14) and a thermally conductive composition coating both sides of the mesh sheet (14) so as to form a thermally conductive layer (15), the thermally conductive composition containing a resin composition and a thermally conductive filler,
    wherein the mesh sheet has mesh holes defined by threads (14a,14b) intersecting with each other, and
    the intersections of the threads (14a,14b) each have a bubble inclusion inhibition part (18), air bubbles being prevented from being trapped in the interface between the thermally conductive composition and the mesh sheet (14),
    wherein the bubble inclusion inhibition part (18) is defined by a fused portion (18a) formed by thermally fusing or welding the threads (14a,14b) at the intersection or is defined by a pressure-bonded portion (18b) formed by pressure-bonding the threads (14a,14b) at the intersections, and
    wherein the bubble inclusion inhibition part (18) is formed by flattering the threads (14a,14b) at their intersection.

2.  The thermally conductive sheet (11,21,31,41,51) according to claim 1,
    wherein the mesh sheet (14) has mesh holes defined by warp threads (14a) and woof threads (14b) extending in two directions in which the threads (14a,14b) intersect with each other, and has a thickness of 50% to 90% of the total of the warp thread (14a) diameter and the woof thread (14b) diameter.

3.  A thermally conductive sheet (11,21,31,41,51) according to claim 2, wherein the mesh holes each have a width of 5 to 40 times of the warp thread (14a) diameter or the woof thread (14b) diameter.

4.  The thermally conductive sheet (11,21,31,41,51) according to any one of claims 1 to 3, wherein the thermally conductive layer is a stack of an adhesive layer (13) and a non-adhesive layer (12), and
    the mesh sheet (14) is embedded in any one of the adhesive layer (13), the non-adhesive layer (12) and the interface between the adhesive layer (13) and the non-adhesive layer (12).

**Patentansprüche**

1.  Thermisch leitfähige Folie (11, 21, 31, 41, 51), die eine Gewebefolie (14) und eine thermisch leitfähige Zusammensetzung, die beide Seiten der Gewebefolie (14) beschichtet, um eine thermisch leitfähige Schicht (15) zu bilden, aufweist, wobei die thermisch leitfähige Zusammensetzung eine Harzzusammensetzung und ein thermisch leitfähiges Füllmaterial aufweist,
    wobei die Gewebefolie Gewebeöffnungen aufweist, die durch einander kreuzende Fäden (14a, 14b) gebildet sind, und wobei die Kreuzungspunkte der Fäden (14a, 14b) jeweils ein Luftblaseneinschluss-Verhinderungsteil (18) aufweisen, wobei verhindert wird, dass Luftblasen in der Schnittstelle zwischen der thermisch leitfähigen Zusammensetzung und der Gewebefolie (14) eingeschlossen werden,
    wobei das Luftblaseneinschluss-Verhinderungsteil (18) durch einen geschmolzenen Bereich (18a) festgelegt ist, der durch thermisches Schmelzen oder Schweißen der Fäden (14a, 14b) an den Kreuzungspunkt gebildet ist, oder durch einen mittels Druck verbundenen Bereich (18b) festgelegt ist, der durch Druckverbinden der Fäden (14a, 14b) an den Kreuzungspunkten gebildet ist, und

wobei das Luftblaseneinschluss-Verhinderungsteil (18) durch Abflachen der Fäden (14a, 14b) an ihrem Kreuzungspunkt gebildet ist.

2. Thermisch leitfähige Folie (11, 21, 31, 41, 51) nach Anspruch 1, wobei die Gewebefolie (14) Gewebeöffnungen aufweist, die durch Kettfäden (14a) und Schussfäden (14b) festgelegt sind, die sich in zwei Richtungen erstrecken, in denen die Fäden (14a, 14b) einander schneiden, und eine Dicke von 50% bis 90% des gesamten Durchmessers des Kettfadens (14a) und des Durchmessers des Kettfadens (14b) aufweist.

3. Thermisch leitfähige Folie (11, 21, 31, 41, 51) nach Anspruch 2, wobei die Gewebeöffnungen jeweils eine Breite von 5 bis 40 Mal des Durchmessers der Kettfäden (14a) oder des Durchmessers der Schussfäden (14b) aufweisen.

4. Thermisch leitfähige Folie (11, 21, 31, 41, 51) nach einem der Ansprüche 1 bis 3, wobei die thermisch leitfähige Schicht ein Stapel einer klebenden Schicht (13) und einer nicht klebenden Schicht (12) ist, und die Gewebefolie (14) in einer der klebenden Schicht (13), der nicht klebenden Schicht (12) und der Schnittstelle zwischen der klebenden Schicht (13) und der nicht klebenden Schicht (12) eingebettet ist.

**Revendications**

1. Feuille thermo-conductrice (11, 21, 31, 41, 51) comprenant une feuille en treillis (14) et une composition thermo-conductrice recouvrant les deux côtés de la feuille en treillis (14) de manière à former une couche thermo-conductrice (15), la composition thermo-conductrice contenant une composition de résine et un garnissage thermo-conducteur, dans laquelle la feuille en treillis a des trous de treillis définis par des fils (14a, 14b) se croisant, et les intersections des fils (14a, 14b) comportent chacune une partie d'inhibition d'inclusion de bulles (18), les bulles d'air étant empêchées d'être piégées dans l'interface entre la composition thermo-conductrice et la feuille en treillis (14), dans laquelle la partie d'inhibition d'inclusion de bulles (18) est définie par une partie fondue (18a) formée par fusion thermique ou soudage des fils (14a, 14b) à l'intersection ou est définie par une partie collée sous pression (18b) formée en collant sous pression les fils (14a, 14b) aux intersections, et dans laquelle la partie d'inhibition d'inclusion de bulles (18) est formée en aplatissant les fils (14a, 14b) à leur intersection.

2. Feuille thermo-conductrice (11, 21, 31, 41, 51) selon la revendication 1, dans laquelle la feuille en treillis (14) présente des trous de treillis définis par des fils de chaîne (14a) et des fils de trame (14b) s'étendant dans deux directions dans lesquelles les fils (14a, 14b) se croisent, et a une épaisseur de 50% à 90% du diamètre total du fil de chaîne (14a) et du diamètre du fil de trame (14b).

3. Feuille thermo-conductrice (11, 21, 31, 41, 51) selon la revendication 2, dans laquelle les trous de treillis ont chacun une largeur de 5 à 40 fois le diamètre du fil de chaîne (14a) ou le diamètre du fil de trame (14b).

4. Feuille thermo-conductrice (11, 21, 31, 41, 51) selon l'une quelconque des revendications 1 à 3, dans laquelle la couche thermo-conductrice est un empilement d'une couche adhésive (13) et d'une couche non-adhésive (12), et la feuille en treillis (14) est intégrée dans l'une quelconque des couches adhésives (13), des couches non-adhésives (12) et de l'interface entre la couche adhésive (13) et la couche non-adhésive (12).

Fig.1

Fig.2

Fig.3

Fig.4

14a   14a   14a   14a   14a

14b

14b

14b

14b

Fig.5

4b   A   4a   4

A

Fig.6

14b   14a   18a (18)   14

Fig.7

Fig.8

Fig.9

Fig.10

Fig.11

Fig.12

Fig.13

Fig.14

## Fig.15

## Fig.16

## Fig.17

## Fig.18

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7014950 A
- JP 7266356 A
- WO 9502505 A1